# EUROPÄISCHE PATENTSCHRIFT

(11) **EP 2 609 021 B1**
(45) Veröffentlichungstag und Bekanntmachung des Hinweises auf die Patenterteilung: **29.10.2014**
(21) Anmeldenummer: 11734061.2
(22) Anmeldetag: 11.07.2011
(51) Int. Cl.: B65G 1/127

(54) **LAGERREGALSYSTEM ZUR LAGERUNG VON LAGERGUT**
STORAGE SHELF SYSTEM FOR STORING STORAGE GOODS
SYSTÈME DE RAYONNAGE POUR LE STOCKAGE DE PRODUITS À STOCKER

(30) Priorität: 24.08.2010 DE 102010035231
(43) Veröffentlichungstag der Anmeldung: 03.07.2013
(73) Patentinhaber: Hänel & CO., 9450 Altstätten (CH)
(72) Erfinder: HÄNEL, Joachim, 74177 Bad Friedrichshall (DE)
(74) Vertreter: Flügel Preissner Kastel Schober
(86) Internationale Anmeldenummer: PCT/EP2011/061774
(87) Internationale Veröffentlichungsnummer: WO 2012/025290

(56) Entgegenhaltungen:
- EP-A2- 1 857 381
- DE-A1- 10 225 332
- DE-A1-102007 040 863
- DE-B1- 2 114 962
- DE-U1- 9 111 388
- US-A- 5 595 263
- US-A1- 2004 101 386

## Beschreibung

Die Erfindung betrifft ein Lagerregalsystem zur Lagerung von Lagergut mit wenigstens einer Bedienöffnung zur Einlagerung und zur Entnahme von Lagergut.

Grundsätzlich sind verschiedene Lagerregaltypen bekannt. Je nach zu lagernden Lagergüter und vorhandenem Platz zur Unterbringung der Lagerregale wird der geeignete Lagerregaltyp gewählt. Es soll ein schneller Zugriff auf die Lagergüter ohne große Zeitverluste möglich sein. Insbesondere bei Hochregallagern können sich infolge der hohen Abmessungen der Lagerregale lange Fahrtzeiten zur Ein- oder Auslagerung ergeben.

Zum einen sind Lagerregale nach dem Paternoster-Prinzip, das häufig auch als Umlaufprinzip bezeichnet wird, bekannt. Weiterhin sind Lagerregale bekannt, die zwei gegenüberliegende Regalsäulen und einen dazwischen liegenden Transportschacht aufweisen, wobei in dem Transportschacht ein Regalförderer auf- und abfährt und die Lagergüter den Lagerplätzen zustellt oder diese aus den Lagerplätzen entnimmt. Diese Lagerregale werden häufig auch als Lagerlift oder Vertikallagerregal bezeichnet.

Je nach Lagerraumbedarf und Anzahl der zu lagernden Lagergüter werden mehrere solcher Lagerregaleinheiten nebeneinander stehend zur Ausbildung eines Lagersystems aufgestellt. In der Regel weist jede Lagerregaleinheit eine Bedienöffnung auf.

Aus der DE 203 05 773 U1 ist ein Lagersystem mit drei Lagerliften bekannt, wobei die Lagerlifte jeweils eine Bedienöffnung aufweisen und diese Bedienöffnungen eine Arbeitsfläche an wenigstens drei Seiten umgrenzen. Jeder Lagerlift weist gegenüberliegende Regalsäulen, einen mittleren Transportschacht und eine in diesem Transportschacht verfahrbare Fördereinheit auf.

Es hat sich jedoch als nachteilig herausgestellt, dass infolge der Anordnung jeweils einer Bedienöffnung in jedem der Lagerlifte viel Lagerplatz verloren geht. Ferner wird auch dadurch viel Lagerkapazität verloren, dass in jedem der Lagerlifte ein Transportschacht mit einem zugehörigen Regalförderer vorgesehen ist. Zudem muss die Bedienperson für den Fall, dass drei eingelagerte Lagergüter benötigt werden, von denen sich jedes Lagergut in einem anderen Lagerregal befindet, jedes Lagerregal bedienen und aus jeder Bedienöffnung das Lagergut einzeln entnehmen. Dadurch ist eine Handhabung mehrerer Lagerregale und ein erhöhter Zeitaufwand erforderlich.

In DE 91 11 388 U1 geht eine Lageranordnung für Lagergut, entsprechend dem Oberbegriff des Anspruchs 1, mit zumindest einem Paternosterlager und einem Regallager, die miteinander kombiniert sind, hervor. Das Paternosterlager weist eine Vielzahl von Tragsätzen für das Lagergut auf, die in einem Gehäuse angeordnet sind. Zum Be- und Entladen der Tragsätze ist in dem Gehäuse eine Beschickungsöffnung eingebracht. An das Paternosterlager schließt sich das Regallager an, das eine Vielzahl von vertikal übereinander angeordneten Lagerebenen für das Lagergut umfasst. Die Beschickung der Lagerebenen mit dem Lagergut erfolgt dadurch, dass eines der Tragsätze des Paternosterlagers als Beschickungstragsatz verwendet wird. Mittels eines Manipulators wird das Lagergut zwischen dem Beschickungstragsatz und der entsprechenden Lagerebene umgesetzt.

EP 1 857 381 A2 offenbart ein Lager und Kommissioniersystem mit mindestens einem Kommissionierplatz, mindestens einem unterhalb und/oder oberhalb des Kommissionierplatzes angeordneten Lagerbereich und einem vertikal ausgerichteten Umlaufförderer, der den Kommissionierplatz mit dem Lagerbereich verbindet, um die Lagerartikel zwischen dem Lagerbereich und dem Kommissionierplatz zu fördern. Der Umlaufförderer weist einen aufwärts laufenden Strang und einen abwärts laufenden Strang auf, wobei ein Kommissionierplatz mit einem der Stränge versorgt und mit einem der Stränge entsorgt wird. Angrenzend an den Umlaufförderer ist eine Übergabevorrichtung zur Übergabe der Artikel von dem Lagerbereich an den Umlaufförderer vorgesehen.

Aus DE 102 25 332 A1 geht ein Einlagerungspuffer für ein automatisiertes Stückgutlager, das als ein Regallager mit mehreren Regalböden ausgebildet ist, hervor. Der Einlagerungspuffer ist als Paternoster ausgebildet und mit einer Vielzahl an Fächern oder Lagerflächen, die über eine Aufhängung mit dem Paternoster verbunden sind, versehen. In einer Verkleidungswand des Einlagerungspuffers ist eine Öffnung eingebracht, die als Beschickungsstation zum Be- oder Entladen der Fächer mit Stückgütern dient. An der Rückseite des Paternosters ist zum Einlagern in das Regallager eine Entnahmestation angeordnet, aus der ein Stückgut von der Lagerfläche durch ein Bediengerät entnommen und in das Regallager eingelagert wird.

Der Erfindung liegt die Aufgabe zugrunde, ein Lagerregalsystem anzugeben, bei dem akzeptable Zugriffszeiten für die Ein- und Auslagerung der Lagergüter, eine möglichst umfangreiche Raumausnutzung mit viel Lagerkapazität und zugleich eine einfache Bedienbarkeit erreicht wird.

Zur Lösung dieser Aufgabe ist ein Lagerregalsystem zur Lagerung von Lagergut mit wenigstens einer Bedienöffnung zur Einlagerung und zur Entnahme von Lagergut, mit wenigstens einem Umlauflagerregal mit mehreren Lagerplätzen und mit wenigstens einem Lagerregal vorgesehen, das wenigstens eine Regalsäule mit übereinander angeordneten Lagerplätzen aufweist. Ferner ist wenigstens eine Übergabevorrichtung vorgesehen, die ausgebildet und eingerichtet ist, das Lagergut von einem Lagerplatz des Lagerregals auf die Übergabevorrichtung und von dort zu einem Lagerplatz des Umlauflagerregals und umgekehrt zu transportieren, wobei die Übergabevorrichtung in vertikaler und/oder horizontaler Richtung verfahrbar ist. Darüber hinaus ist zwischen dem wenigstens einen Umlauflagerregal und dem wenigstens einen Lagerregal ein Transportschacht vorgesehen, in dem die Übergabevorrichtung in vertikaler und/oder horizontaler Richtung verfahrbar ist. Die Übergabevorrichtung ist ausgebildet und eingerichtet, um das Lagergut von einem Lagerplatz des Umlauflagerregals auf die Übergabevorrichtung und von dort in die Bedienöffnung und umgekehrt zu transportieren. Ferner ist die Übergabevorrichtung ausgebildet und eingerichtet, um das Lagergut von einem Lagerplatz des Lagerregals auf die Übergabevorrichtung und von dort in die Bedienöffnung und umgekehrt zu transportieren.

Im Rahmen der vorliegenden Anmeldung wird unter dem "Lagerregal" vorzugsweise eine Regalsäule verstanden, die eine Vielzahl von übereinander liegenden Lagerplätzen bereitstellt. Jeder dieser Lagerplätze kann insbesondere einen Lagergutträger mit dem darauf befindlichen Lagergut aufnehmen. Ferner können zur Bildung einer Regalreihe mehrere Regalsäulen nebeneinander positioniert werden. Das Lagerregal kann auch als Lagerlift oder Vertikallagerregal bezeichnet werden.

Soweit in der vorliegenden Anmeldung von einem Lagergutträger gesprochen wird, kann dieser Begriff durch das zu transportierende Lagergut ersetzt oder ergänzt werden. Ferner kann das Lagergut ein einzelnes Lagergutelement oder eine Zusammenstellung mehrerer Lagergutelemente betreffen. Vorzugsweise wird das ein- und auszulagernde Lagergut mit Lagergutträgern transportiert und gelagert.

Das erfindungsgemäße Lagerregalsystem beruht zunächst auf der Erkenntnis, verschiedene Lagerregaltypen in einem Gesamtsystem zu kombinieren, so dass eine gute Raumausnutzung bei geringen Zugriffszeiten erfolgt und eine Verknüpfung der verschiedenen Lagerregale und somit ein Austausch von Lagergütern zwischen den Lagerregalen möglich ist. Diese Verknüpfung ermöglicht beispielsweise, dass ein Lagergut, das zunächst in einem Lagerplatz des Umlauflagerregals gelagert ist, nach Bearbeitung in einen Lagerplatz des Lagerregals eingelagert werden kann. Ferner können Lagergüter auch ohne dass diese der Bedienöffnung zugestellt werden, innerhalb des Gesamtsystems umgelagert werden kann. Beispielsweise können Lagergüter aus dem Bereich des Umlauflagerregals in den Bereich des Lagerregals und umgekehrt umgelagert oder umsortiert werden.

Das erfindungsgemäße Lagerregalsystem umfasst wenigstens eine Übergabevorrichtung, die ausgebildet und eingerichtet ist, um das Lagergut von einem Lagerplatz des Lagerregals auf die Übergabevorrichtung und von dort zu einem Lagerplatz des Umlauflagerregals oder in die Bedienöffnung zu transportieren oder zu bewegen. Ferner ist die Übergabevorrichtung ausgebildet und eingerichtet, um das Lagergut von einem Lagerplatz des Umlauflagerregals auf die Übergabevorrichtung und von dort zu einem Lagerplatz des Lagerregals oder in die Bedienöffnung zu transportieren oder zu bewegen. Auch die umgekehrten Bewegungen werden ausgeführt.

Vorteilhafte Ausgestaltungen des erfindungsgemäßen Lagerregalsystems sind in den abhängigen Ansprüchen beansprucht.

Vorzugsweise ist das Lagerregalsystem als Hochregallager ausgebildet, wobei der Transportschacht vorzugsweise in vertikaler Richtung und/oder vorzugsweise etwa mittig im System angeordnet ist. Auf diese Weise ist es in vorteilhafter Weise möglich, mittels der in dem Transportschacht verfahrbaren Übergabevorrichtung die Lagergüter von einem Lagerplatz des Umlauflagerregals der Bedienöffnung des Lagerregalsystems und/oder von einem Lagerplatz des Lagerregals der Bedienöffnung schnell zuzustellen. Somit kann unter einer hohen Ausnutzung des verfügbaren Raumes zur Lagerung der Lagergüter ein effizientes Lagerregalsystem geschaffen werden.

In bevorzugter Ausgestaltung umfasst die Übergabevorrichtung einen Vertikalförderer, vorzugsweise in Form einer Plattform, wobei mit dem Vertikalförderer das Lagergut in vertikaler Richtung verfahrbar ist. Vorzugsweise umfasst der Vertikalförderer eine Plattform und ein Antriebsmittel, das die Plattform in vertikaler Richtung verfährt.

Weiterhin kann die Übergabevorrichtung wenigstens einen Horizontalförderer umfassen, mit dem das Lagergut in horizontaler Richtung verfahrbar ist. Weiterhin kann vorgesehen werden, dass sich der Horizontalförderer auf dem Vertikalförderer abstützt. Vorzugsweise ist der Horizontalförderer bezüglich des Vertikalförderers in horizontaler Richtung bewegbar. Auf diese Weise kann ein Transport des Lagerguts in Vertikalrichtung und gleichzeitig in Horizontalrichtung erfolgen. Sofern im Rahmen dieser Anmeldung auf eine horizontale Richtung Bezug genommen wird, kann hierbei eine erste horizontale Richtung oder eine zweite horizontale Richtung der Horizontalebene gemeint sein.

Die Übergabevorrichtung, der Horizontalförderer und/oder der Vertikalförderer können beispielsweise als Greifeinheit und/oder Zieheinheit ausgebildet sein.

Um beispielsweise gleichzeitig oder mindestens in zeitlicher Überschneidung mehrere Lagergüter aus verschiedenen Lagerplätzen der Bedienöffnung oder umgekehrt zuzustellen, können auch mehrere Übergabevorrichtungen in dem Transportschacht vorgesehen werden. Des Weiteren kann die einzelne Übergabevorrichtung auch mehrere Vertikalförderer und/oder Horizontalförderer umfassen.

Bei einer weiteren bevorzugten Ausführungsform umfasst die Übergabevorrichtung, vorzugsweise der Horizontalförderer, wenigstens eine Übergabeeinheit, um das Lagergut von einem Lagerplatz des Umlauflagerregals auf die Übergabevorrichtung und von einem Lagerplatz des Lagerregals auf die Übergabevorrichtung und von der Übergabevorrichtung in die Bedienöffnung zu befördern.

Weiterhin kann das Umlauflagerregal ein Antriebsmittel aufweisen, an dem über eine Trageinheit ein Tragsatz zur Halterung eines Lagergutträgers gehalten ist.

Alle vorgenannten Antriebsmittel umfassen vorzugsweise wenigstens einen Kettenantrieb und/oder einen Zahnradantrieb.

In bevorzugter Ausgestaltung ist der jeweilige Tragsatz fest an der zugehörigen Trageinheit angebracht und dient zur Halterung oder Aufnahme eines Lagergutträgers. Ferner kann der jeweilige Tragsatz lösbar an der zugehörigen Trageinheit angebracht sein und zur Halterung des Lagergutträgers dienen. Hierbei kann beispielsweise eine Steckverbindung verwendet werden.

Vorzugsweise weist die Regalsäule übereinander liegende und beabstandete Trägerauflagen auf, die paarweise an sich gegenüber liegenden Seitenwänden der Regalsäule zur Bildung eines Lagerplatzes für das Lagergut und/oder die Lagergutträger angeordnet sind.

Um die übereinander liegenden Lagerplätze auszubilden, weist das Lagerregal vorzugsweise paarweise Trägerauflagen auf. Diese Trägerauflagen können an vertikalen Seitenwänden angebracht sein.

Vorteilhafterweise sind die Trägerauflagen rasterartig an den Seitenwänden vorgesehen. Durch Vorgabe eines bestimmten Rastermasses und Hinterlegung dieses Rasters in einer Steuereinheit der Übergabevorrichtung kann insbesondere in Verbindung mit einer Höhenmesseinrichtung ein für eine bestimmte Lagerguthöhe ausreichender Lagerplatz zugeordnet werden. Vorteilhafterweise sind die Trägerauflagen mäanderförmig in die Seitenwände eingepresst. Die Seitenwände sind insbesondere aus Stahlblech hergestellt und können mit vertikalen Regalständern verschweißt sein. Zusätzlich oder alternativ können die Trägerauflagen Nuten aufweisen, in die Auflagestege der Lagergutträger ein- und ausführbar sind. Derartige Auflagestege können an den Seitenwänden der Lagergutträger angebracht sein.

In bevorzugter Ausgestaltung sind Regalständer zur Halterung der Seitenwände des Lagerregalsystems, zur Führung der Übergabevorrichtung in vertikaler Richtung, zur Stützung des Lagerregals und/oder zur Stützung des Umlauflagerregals vorgesehen.

Die Regalständer können im Bereich des Transportschachtes so angeordnet sein, dass die Übergabevorrichtung, insbesondere der Vertikalförderer, mittels Rädern oder Rollen an den Regalständern geführt ist. Beispielsweise können die Regalständer mit Führungsschienen versehen sein, in denen die Räder beziehungsweise Rollen geführt sind. Ferner kann es vorgesehen sein, dass ein Regalständer oder mehrere Regalständer sowohl zur Stützung wenigstens eines Lagerregals oder Regalsäule als auch zur Ausbildung des Transportschachtes mit der Führung und Stützung der Übergabevorrichtung vorgesehen sind.

Für das Lagerregalsystem können je nach vorhandenen Platzverhältnissen vorbestimmte Lagerregalsystemeinheiten als Module bereitgestellt werden, die dann gegebenenfalls nebeneinander aufgestellt werden, um ein Modulsystem zu schaffen. Die nebeneinander aufgestellten Moduleinheiten können jeweils als einzelne Einheit funktionieren oder können untereinander miteinander verknüpft sein, insbesondere über die Übergabevorrichtung und/oder den Transportschacht. Hierbei haben sich folgende Ausführungsformen als besonders vorteilhaft erwiesen:
In bevorzugter Ausgestaltung sind wenigstens zwei Lagerregale, wenigstens ein Umlauflagerregal und wenigstens eine Übergabevorrichtung vorgesehen. Bei einer ersten Variante dieser Ausgestaltung sind vorzugsweise zwei Lagerregale, ein Umlauflagerregal und zwei Übergabevorrichtungen enthalten sind. Bei einer weiteren Variante können zwei Lagerregale, zwei Umlauflagerregale und eine Übergabevorrichtung vorgesehen sein.

Vorzugsweise weist das Umlauflagerregal wenigstens einen Übergabebereich auf, über den das Lagergut von dem Umlauflagerregal zu der Übergabevorrichtung und umgekehrt zugeführt werden kann.

Dieser Übergabebereich kann im oberen Umlenkbereich, im unteren Umlenkbereich und/oder in einem Bereich zwischen oberen und unteren Umlenkbereich des Umlauflagerregals ausgebildet sein.

Anders ausgedrückt, können Umlauflagerregal und Übergabevorrichtung derart ausgestaltet und eingerichtet sind, dass die Übergabe des Lagerguts mittels der Übergabevorrichtung zwischen Umlauflagerregal und Lagerregal im Bereich des oberen und/oder des unteren Umlenkbereiches des Umlauflagerregals erfolgt. Ferner können Umlauflagerregal und Übergabevorrichtung derart ausgestaltet und eingerichtet sein, dass die Übergabe des Lagerguts mittels der Übergabevorrichtung zwischen Umlauflagerregal und Lagerregal in einem Bereich zwischen dem oberen und unteren Umlenkbereich des Umlauflagerregals erfolgt.

Bei einer bevorzugten Weitergestaltung kann vorzugsweise ein Pufferbereich vorgesehen werden, in dem eine Übergabevorrichtung und/oder ein Lagergut oder Lagergutträger zwischengelagert werden kann. Später kann dann das Lagergut oder der Lagergutträger der Bedienöffnung oder einem Lagerplatz zugestellt werden. Der Pufferbereich kann vorzugsweise in dem Lagerregal, weiter vorzugsweise oberhalb oder unterhalb der Bedienöffnung angeordnet werden. Des Weiteren kann beispielsweise bei einer Verwendung mehrerer Übergabevorrichtungen in dem Transportschacht eine der Übergabevorrichtungen in dem Pufferbereich geparkt werden.

Das Lagerregalsystem kann nur eine oder auch mehrere Bedienöffnungen umfassen, was sich insbesondere dann als vorteilhaft erweist, wenn die Wartezeiten und/oder Zugriffszeiten möglichst reduziert werden sollen. Im Bereich der wenigstens einen Bedienöffnung kann eine Höhenmesseinrichtung zur Erfassung der Höhe des Lagerguts vorgesehen sein. Eine solche Höhenmesseinrichtung kann die Anzahl der für die Lagerung des Lagerguts notwendigen Höheneinheiten ermitteln.

Nachfolgend wird die Erfindung unter Bezugnahme auf die Zeichnungen weiter erläutert. Dabei zeigen schematisch:
- Fig. 1: eine perspektivische Darstellung einer ersten Ausführungsform des erfindungsgemäßen Lagerregalsystem;
- Fig. 2: eine Draufsicht auf das Lagerregalsystem gemäß Fig. 1;
- Fig. 3: einen Seitenansicht auf das Lagerregalsystem gemäß dem Pfeil III in Fig. 1;
- Fig. 4: einen Querschnitt gemäß der Linie IV - IV in Fig. 2;
- Fig. 5: einen Querschnitt durch die Seitenwände des Lagerregals;
- Fig. 6: eine perspektivische Darstellung einer zweiten Ausführungsform des erfindungsgemäßen Lagerregalsystem;
- Fig. 7: einen horizontalen Schnitt durch die zweite Ausführungsform gemäß Fig. 6;
- Fig. 8: einen horizontalen Schnitt durch eine dritte Ausführungsform des erfindungsgemäßen Lagerregalsystems, und
- Fig. 9: eine perspektivische schematische Darstellung der in Fig. 8 verwendeten Übergabevorrichtung.

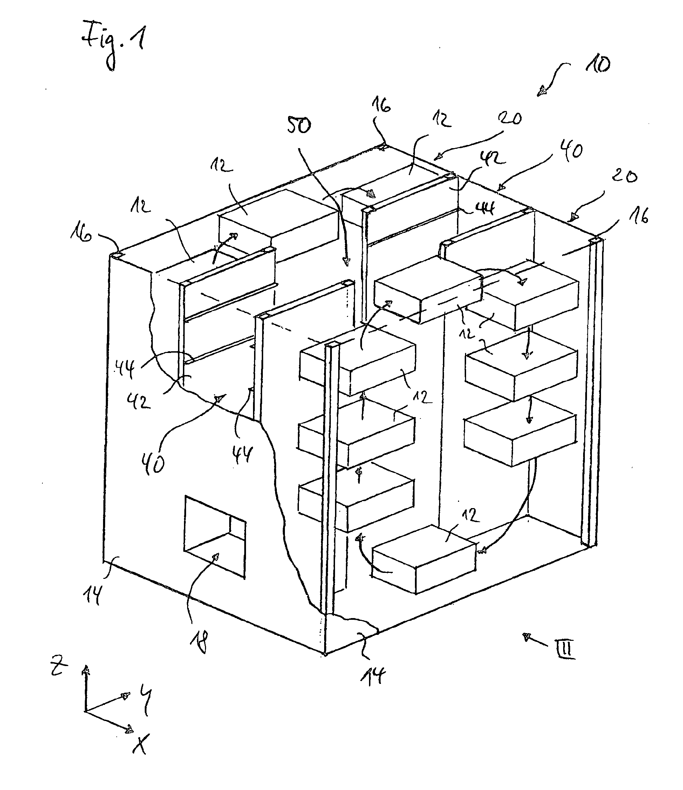

Fig. 1 zeigt in einer perspektivischen Darstellung den schematischen Aufbau einer ersten Ausführungsform des erfindungsgemäßen Lagerregalssystems 10 zur Lagerung von Lagergut 12. Das Lagerregalsystem 10 umfasst zwei Umlauflagerregale 20 und zwei Lagerregale 40 und eine Bedienöffnung 18 zur Einlagerung und Entnahme von Lagergut 12.

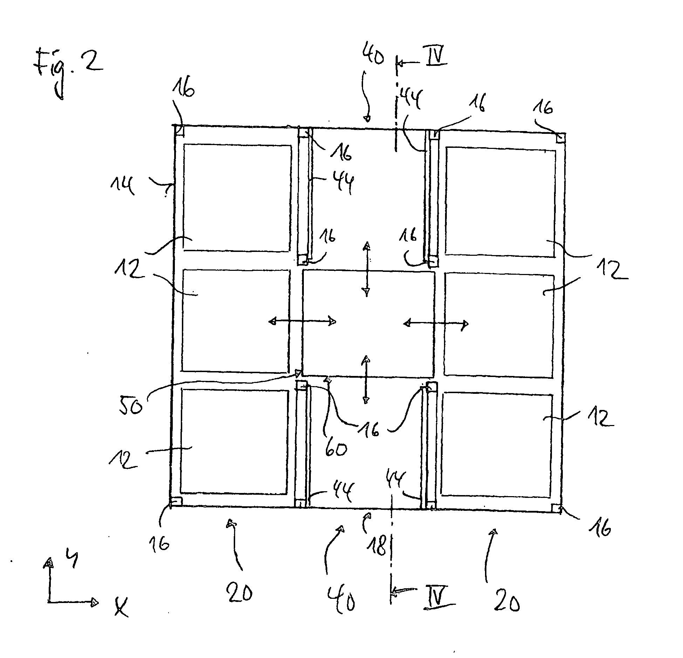

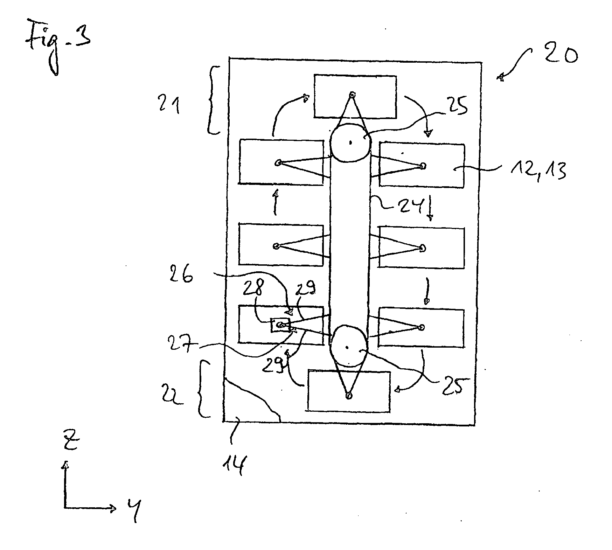

Fig. 2 zeigt eine Draufsicht auf das Lagerregalsystem 10 gemäß Fig. 1. Ferner zeigt Fig. 3 eine Seitenansicht von außen auf das Lagerregalsystem 10 im Bereich des Umlauflagerregals 20, wobei die Außenwand 14 teilweise geschnitten dargestellt ist. In den Fig. 1 bis 3 sind in den Bereichen der Umlauflagerregale 20 eine Vielzahl von Lagergütern 12 rein schematisch dargestellt. Vorzugsweise wird das ein- und auszulagernde Lagergut 12 mit Lagergutträgern transportiert und gelagert. Soweit also in der Figurenbeschreibung von Lagergut 12 gesprochen wird, kann dieser Begriff durch den jeweiligen Lagergutträger ersetzt oder ergänzt werden. Ferner kann das Lagergut 12 ein einzelnes Lagergutelement oder eine Zusammenstellung mehrerer Lagergutelemente betreffen. Ferner sind zur einfacheren Darstellbarkeit in Fig. 1 die Antriebsmittel und Tragmittel für die Umlauflagerregale 20 nicht dargestellt.

Die zwei Lagerregale 40 sind jeweils durch eine Regalsäule mit übereinander angeordneten Lagerplätzen gebildet. Bezüglich der Bedienöffnung 18 ist ein Lagerregal 40 im vorderen Bereich und ein Lagerregal 40 im hinteren Bereich des Lagerregalsystems 10 angeordnet. Um die übereinanderliegenden Lagerplätze für die Lagergüter 12 im Bereich der Lagerregale 40 zu bilden, weist jedes der Lagerregale 40 paarweise Trägerauflagen 44 auf. Diese Trägerauflagen 44 sind an sich gegenüber liegenden Seitenwänden 42 der Lagerregale 40 angeordnet.

Zur Stützung der Lagerregale 40 und zur Befestigung der Seitenwände 42 sind mehrere Regalständer 16 vorgesehen. Wie aus Fig. 1 zu entnehmen, sind noch weitere Regalständer 16 auch im Bereich der Umlauflagerregale 20 vorgesehen, um die Umlauflagerregale 20 und das Lagerregalsystem 10 insgesamt abzustützen und eine umlaufende Außenwand 14 zu befestigen.

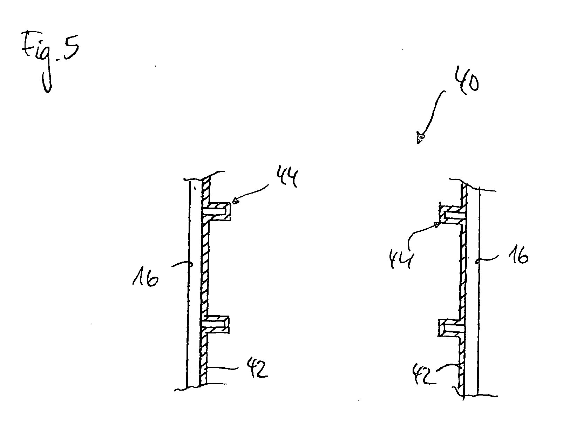

Wie insbesondere aus Fig. 5 zu erkennen, sind die Trägerauflagen 44 rasterartig an den Seitenwänden 42 der Lagerregale 40 vorgesehen. Die Trägerauflagen 44 sind vorzugsweise mäanderförmig in die Seitenwände 42 eingepresst. Die Seitenwände 42 sind insbesondere aus Stahlblech hergestellt und können mit den Regalständern 16 verschweißt sein.

Wie insbesondere aus den Fig. 1 und 2 zu erkennen, ist in einer ersten Horizontalrichtung X zwischen den Lagerregalen 40 betrachtet ein in Vertikalrichtung Z verlaufender Transportschacht 50 vorgesehen. Dieser Transportschacht 50 ist ferner in einer zweiten Horizontalrichtung Y betrachtet zwischen den beiden Umlauflagerregalen 20 und somit insgesamt etwa mittig in dem Lagerregalsystem 10 vorgesehen.

In dem Transportschacht 50 ist eine Übergabevorrichtung 60 vorgesehen, mit der das Lagergut 12 oder der Lagergutträger von einem Lagerregal 40 zu einem Umlauflagerregal 20 und umgekehrt transportiert werden kann. Ferner ist die Übergabevorrichtung 60 eingerichtet, um das Lagergut 12 aus dem jeweiligen Lagerplatz eines Lagerregals 40 oder eines Umlauflagerregals 20 auf die Übergabevorrichtung 60 und von dort in einen anderen Lagerplatz innerhalb des Lagerregalsystems 10 und/oder in den Bereich der Bedienöffnung 18 zu bewegen. Selbstverständlich sind alle vorgenannten Bewegungen auch in umgekehrter Richtung möglich. Die möglichen horizontalen Bewegungen sind mittels Doppelpfeilen in Fig. 2 gekennzeichnet. Ferner können die Lagergüter 12 in dem Transportschacht 50 mittels der Übergabevorrichtung 60 in Vertikalrichtung Z befördert werden.

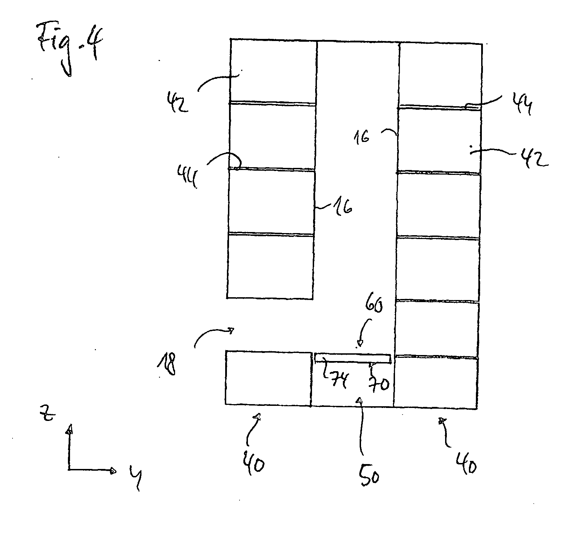

Die Übergabevorrichtung 60 ergibt sich insbesondere aus den Fig. 2 und 4 und umfasst einen Vertikalförderer 70, mit dem das Lagergut in der Vertikalrichtung Z verfahrbar ist und wenigstens einen Horizontalförderer, mit dem das Lagergut in der ersten Horizontalrichtung X und/oder in der zweiten Horizontalrichtung Y verfahrbar ist. Der Vertikalförderer 70 ist in Form einer Plattform 74 ausgebildet. Zum vertikalen Verfahren innerhalb des Transportschachtes 50 kann als Antriebsmittel vorzugsweise ein Kettenantrieb 72 vorgesehen sein.

Als Horizontalförderer sind vorzugsweise mehrere Greifeinheiten angeordnet, die das Lagergut 12 oder den Lagergutträger in Richtung der ersten Horizontalrichtung X und/oder der zweiten Horizontalrichtung Y verfahren können, wie auch durch die Doppelpfeile in Fig. 2 ersichtlich. Mittels dieser Greifeinheiten kann ein in dem Umlauflagerregal 20 befindliches Lagergut 12 auf die Übergabevorrichtung 60 gezogen werden. Von dort kann das Lagergut 12 mittels des Vertikalförderers 70 in dem Transportschacht 50 in Vertikalrichtung Z verfahren werden und dann beispielsweise in einen freien Lagerplatz eines der Lagerregale 40 eingeschoben werden. Alternativ kann das Lagergut 12 mittels des Horizontalförderers, insbesondere einer oder mehrerer Greifeinheiten, von der Übergabevorrichtung 60 in die Bedienöffnung 18 befördert werden, so dass die Bedienperson das Lagergut 12 entnehmen kann. Weiterhin ist die Übergabevorrichtung 60 mit ihrem Horizontalförderer und ihrem Vertikalförderer 70 derart eingerichtet, dass ein Lagergut 12 aus einem Lagerplatz eines der Lagerregale 40 heraus und auf die Übergabevorrichtung 60 und dann in die Bedienöffnung 18 oder in einen freien Lagerplatz des anderen oder des gleichen Lagerregals 40 gezogen werden kann.

Fig. 3 zeigt eine Seitenansicht auf das Umlauflagerregal 20 gemäß des Pfeils III in Fig. 1. Hierbei sind schematisch das Antriebsmittel zur Erzeugung einer Umlaufbewegung und mehrere Tragmittel 26 zur Halterung der Lagergüter 12 oder Lagergutträger dargestellt. Das Antriebsmittel umfasst einen Kettenantrieb 24 mit einer oberen Umlenkrolle 25 und einer unteren Umlenkrolle 25. Die Kette ist derart angetrieben, dass die Lagergüter 12 in vertikaler Richtung nach dem Paternosterprinzip umlaufen und im Bereich der oberen Umlenkrolle 25 sowie im Bereich der unteren Umlenkrolle 25 umgelenkt werden. Im Bereich der oberen Umlenkrolle 25 befindet sich ein oberer Umlenkbereich 21 und im Bereich der unteren Umlenkrolle 25 ein unterer Umlenkbereich 22. Eine mögliche Umlaufrichtung ist in Fig. 3 mit Pfeilen gekennzeichnet. Der Umlauf kann auch in umgekehrter Richtung erfolgen.

An dem Kettenantrieb 24 sind mehrere Tragmittel 26 zur Halterung der Lagergutträger vorgesehen. Jedes Tragmittel 26 umfasst eine Trageinheit 27, die wenigstens einen, vorzugsweise mehrere, insbesondere zwei oder vier Tragarme 29 umfasst, um einen Tragsatz 28, den Lagergutträger und/oder das Lagergut 12 halten zu können. Die Tragarme 29 sind an ihren jeweiligen Enden gelenkig an der Kette und dem Tragsatz 28 angebracht, so dass die halbkreisförmige Umlenkbewegung im oberen Umlenkbereich 21 und unteren Umlenkbereich 22 erfolgen kann. Ferner kann eine Führungsschiene zur Führung der lagergutseitigen Enden der Tragarme 29 vorgesehen sein (nicht dargestellt). Bei der ersten Ausführungsform des Lagerregalsystems 10 ist vorgesehen, dass die Übergabe der Lagergüter 12 zwischen Umlauflagerregal 20 und Lagerregal 40 im oberen Umlenkbereich 21 oder im unteren Umlenkbereich 22 mittels der oben genannten Greifeinheiten des Horizontalförderers der Übergabevorrichtung 60 erfolgt.

Bei einer ersten Variante des oben erwähnten Tragmittels 26 ist der jeweilige Tragsatz 28 fest an der zugehörigen Trageinheit 27 angebracht und dient zur Halterung des Lagergutträgers. Vorzugsweise ist dieser Tragsatz 28 dauerhaft fest an den Tragarmen 28 befestigt. Bei einer zweiten Variante ist der jeweilige Tragsatz 28 lösbar an der zugehörigen Trageinheit 27 befestigt, das heißt den Tragarmen 29, angebracht. Beispielsweise kann der Tragsatz 28 mittels einer Steckverbindung lösbar befestigt sein.

Vorzugsweise weisen die in Fig. 1 in den Eckbereichen des Transportschachtes 50 angeordneten Regalständer 16 Führungsmittel auf, um eine vertikale Führung der Übergabevorrichtung 60, insbesondere des Vertikalförderers 70, in Vertikalrichtung Z zu ermöglichen. Hierzu kann insbesondere vorgesehen sein, dass der Vertikalförderer 70 mit Führungsrollen versehen ist, die in vertikalen Führungsschienen entlang der Regalständer 16 geführt sind.

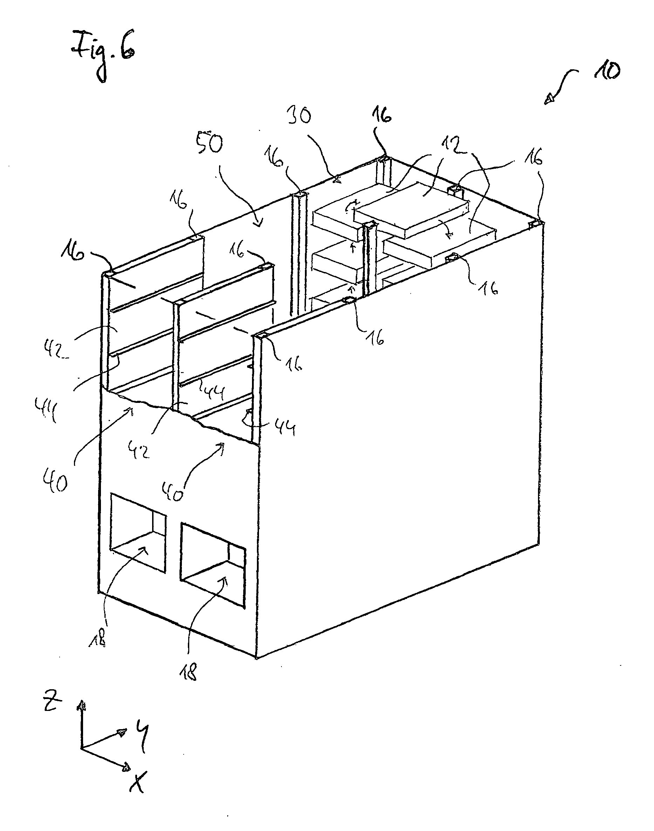

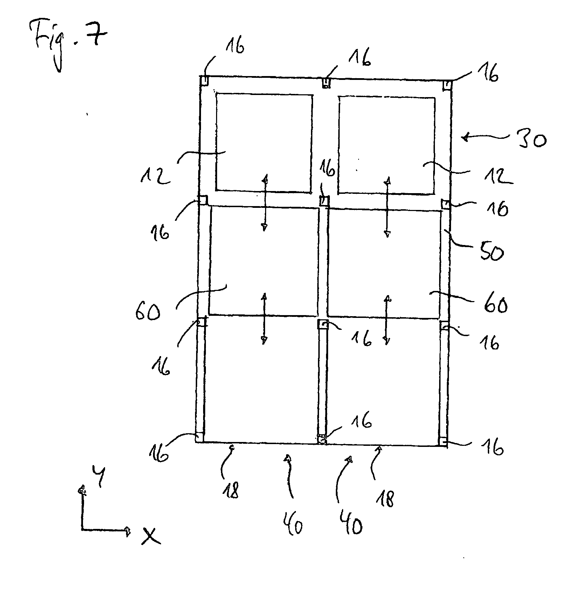

Fig. 6 zeigt in einer perspektivischen Darstellung den schematischen Aufbau einer zweiten Ausführungsform des erfindungsgemäßen Lagerregalssystems 10 zur Lagerung von Lagergut 12. Das Lagerregalsystem 10 umfasst ein Umlauflagerregal 30 und zwei Lagerregale 40 mit je einer Bedienöffnung 18 zur Einlagerung und Entnahme von Lagergut 12. Es kann aber auch nur eine einzige Bedienöffnung 18 vorgesehen werden. Fig. 7 zeigt in schematischer Darstellung einen horizontalen Schnitt durch diese zweite Ausführungsform gemäß Fig. 6, wobei der horizontale Schnitt auf Höhe der Bedienöffnungen 18 verläuft. Im vorderen Bereich des Lagerregalsystems 10 sind die zwei Lagerregale 40 nebeneinander angeordnet. Diese Lagerregale 40 entsprechen hinsichtlich ihres Aufbaus dem vorderen Lagerregal 40 der ersten Ausführungsform gemäß Fig. 1. Somit weisen diese Lagerregale 40 jeweils an Seitenwänden 42 angeordnete paarweise vorgesehene Trägerauflagen 44 zur Ausbildung von übereinander liegenden Lagerplätzen auf.

Im hinteren Bereich des Lagerregalssystems 10 ist ein Umlauflagerregal 30 vorgesehen, das sich entlang der Horizontalrichtung X erstreckt. Dieses Umlauflagerregal 30 entspricht grundsätzlich und vom schematischen Aufbau her den beiden Umlauflagerregalen 20 der ersten Ausführungsform (siehe Fig. 1 bis 3). Somit kann zunächst auf obige Ausführungen verwiesen werden. Im Unterschied zu der ersten Ausführungsform sind bei der zweiten Ausführungsform gemäß Fig. 6, 7 zwei Übergabevorrichtungen 60 vorgesehen, die jeweils gleichermaßen wie die oben zu der ersten Ausführungsform gemäß Fig. 1 erläuterte Übergabevorrichtung 60 ausgebildet sind. Dementsprechend sind auch die Maßnahmen zur Führung der beiden Übergabevorrichtungen 60 in dem Transportschacht 50 mittels an den Regalständern angebrachter Führungsschienen ausgebildet und eingerichtet. Als weiterer Unterschied zur ersten Ausführungsform werden bei der zweiten Ausführungsform die Lagergutträger mittels der Übergabevorrichtung(en) 60 nicht im Bereich eines oberen oder unteren Umlenkbereiches, sondern in einem mittleren Bereich zwischen oberen und unteren Umlenkbereich aus einem Lagerplatz des Umlauflagerregals 30 entnommen und auf die Übergabevorrichtung 60 befördert. Dies ist anhand der Doppelpfeile in der Horizontalrichtung Y in Fig. 7 erkennbar. Mittels der Übergabevorrichtung 60 kann das entnommene Lagergut 12 dann in Vertikalrichtung Z in dem Transportschacht 50 verfahren und in einen Lagerplatz des Lagerregals 40 oberhalb oder unterhalb der Bedienöffnung 18 eingelagert werden. Von der Übergabevorrichtung 60 kann das Lagergut 12 in die Bedienöffnung 18 geschoben werden.

Bei einer Weiterbildung der zweiten Ausführungsform gemäß Fig. 6, 7 kann vorgesehen sein, dass die beiden Übergabevorrichtungen 60 zusätzlich derart eingerichtet sind, dass ein Überführen des Lagerguts und/oder Lagergutträgers von der einen Übergabevorrichtung 60 in Horizontalrichtung X auf die andere Übergabevorrichtung 60 und umgekehrt möglich ist.

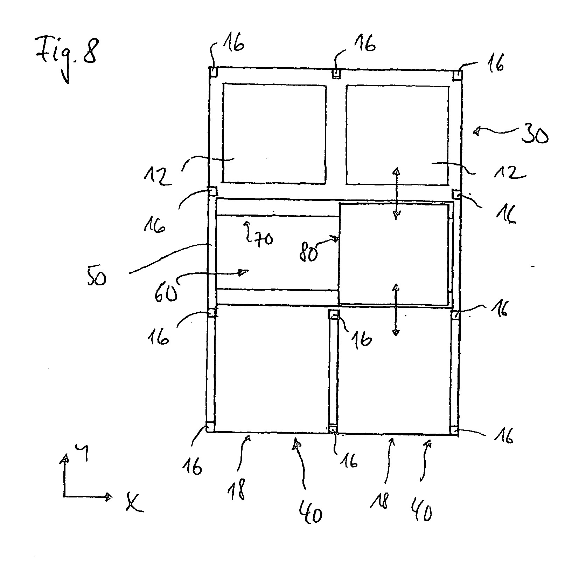

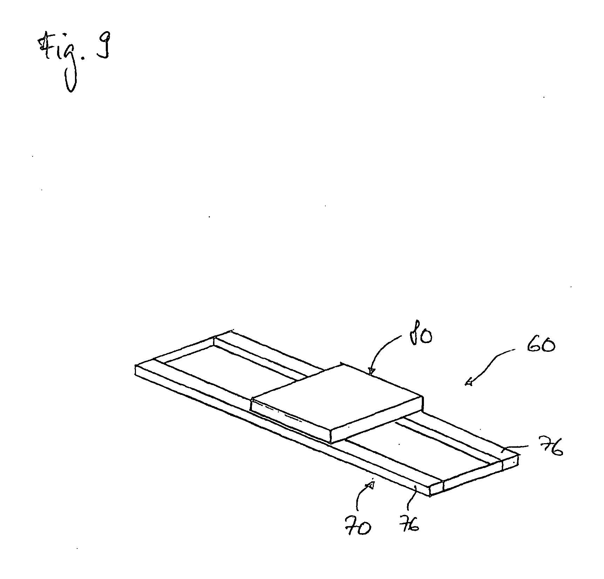

Fig. 8 zeigt einen horizontalen, schematischen Schnitt durch eine dritte Ausführungsform des erfindungsgemäßen Lagerregalsystems 10, wobei der horizontale Schnitt auf Höhe der Bedienöffnung 18 verläuft. Im vorderen Bereich des Lagerregalsystems 10 sind zwei Lagerregale 40 nebeneinander angeordnet, die jeweils eine Bedienöffnung 18 aufweisen. Es kann aber auch nur eine einzige Bedienöffnung 18 vorgesehen werden. Im Unterschied zu der zweiten Ausführungsform gemäß Fig. 6, 7 ist bei der dritten Ausführungsform lediglich eine Übergabevorrichtung 60 in dem Transportschacht 50 vorgesehen, die auch in Fig. 9 schematisch in einer perspektivischen Darstellung gezeigt ist. Diese Übergabevorrichtung 60 umfasst als Vertikalförderer 70 eine Hubbühne, die vorzugsweise aus zwei beabstandeten, parallelen Trägern 76 gebildet ist (siehe auch Fig. 9). Der Horizontalförderer 80 ist beweglich auf dem Vertikalförderer 70, insbesondere auf den beiden Trägern 76, gelagert, stützt sich auf diesem ab und ist bezüglich des Vertikalförderers 70 in der ersten Horizontalrichtung X bewegbar.

Dieser Horizontalförderer 80 umfasst weiterhin, wie schon der oben zu der ersten Ausführungsform erläuterte Horizontalförderer, wenigstens eine Greifeinheit zum Bewegen der Lagergutträger von der Übergabevorrichtung 60 in einen Lagerplatz des Lagerregals 40 oder in einen Lagerplatz des Umlauflagerregals 30 oder in eine der Bedienöffnungen 18 und jeweils umgekehrt. Hierbei können für dieses horizontale Bewegen in der ersten Horizontalrichtung X und/oder der zweiten Horizontalrichtung Y der Lagergutträger in den Lagerplatz und aus dem Lagerplatz heraus beispielsweise eine Greifeinheit oder mehrere Greifeinheiten eingesetzt werden.

Weiterhin sind auch Kombinationen der einzelnen Umlauflagerregale 20 oder 30 mit den Lagerregalen 40 und den verschiedenen Übergabevorrichtungen 60 möglich. Ferner können aus den oben erläuterten Ausführungsformen vorbestimmte Lagerregalsystemeinheiten als Module bereitgestellt werden, die dann je nach vorhandenen Platzverhältnissen nebeneinander aufgestellt werden, um so ein Modulsystem zu schaffen. Diese nebeneinander aufgestellten Moduleinheiten können dann als einzelne Einheiten, beispielsweise mit jeweils einer Bedienöffnung, funktionieren oder können untereinander miteinander verknüpft sein, insbesondere über eine oder mehrere Übergabevorrichtungen 60 und/oder einen oder mehrere Transportschächte 50. Beispielsweise können die in den Figuren 7 und 8 gezeigten Ausführungen jeweils eine solche Moduleinheit bilden, so dass dann insbesondere entlang der Horizontalrichtung X mehrere solche Moduleinheiten nebeneinander angeordnet werden, um ein Lagerregalsystem zu bilden. Insbesondere bei der Ausführung gemäß Fig. 8 kann ein gemeinsamer Transportschacht 50 vorgesehen werden, in dem nur eine Übergabevorrichtung 60 eingesetzt wird.

Die beschriebenen Ausführungsformen des Lagerregalsystems 10 zeichnen sich insbesondere dadurch aus, dass durch die Anordnung eines zentralen, insbesondere mittigen, Transportschachtes 50 mit der Übergabevorrichtung 60 der Verlust an Lagerkapazität minimiert wird. Ferner wird eine Verknüpfung verschiedener Lagerregaltypen erreicht, wodurch es nicht mehr erforderlich ist jedes einzelne Regal zu bedienen und das jeweils in der Bedienöffnung 18 zugestellte Lagergut einzeln zu entnehmen. Dies führt zu einer Reduzierung des Zeitaufwandes. Insgesamt betrachtet, werden eine gute Raumausnutzung mit viel Lagerkapazität und zugleich eine einfache Bedienbarkeit, vorzugsweise mit nur einer Bedienperson, erreicht.

**Bezugszeichenliste**

| | | | |
|---|---|---|---|
| 10 | Lagerregalsystem | | |
| 12 | Lagergut | 50 | Transportschacht |
| 14 | Außenwand | | |
| 16 | Regalständer | 60 | Übergabevorrichtung |
| 18 | Bedienöffnung | | |
| | | 70 | Vertikalförderer |
| 20 | Umlauflagerregal | 72 | Kettenantrieb |
| 21 | Umlenkbereich | 74 | Plattform |
| 22 | Umlenkbereich | 76 | Träger |
| 24 | Kettenantrieb | | |
| 25 | Umlenkrolle | 80 | Horizontalförderer |
| 26 | Tragmittel | | |
| 27 | Trageinheit | X | erste Horizontalrichtung |
| 28 | Tragsatz | Y | zweite Horizontalrichtung |
| 29 | Tragarm | Z | Vertikalrichtung |
| | | | |
| 30 | Umlauflagerregal | | |
| | | | |
| 40 | Lagerregal | | |
| 42 | Seitenwand | | |
| 44 | Trägerauflage | | |

## Patentansprüche

1. Lagerregalsystem (10) zur Lagerung von Lagergut,
mit wenigstens einer Bedienöffnung (18) zur Einlagerung und zur Entnahme von Lagergut (12),
mit wenigstens einem Umlauflagerregal (20, 30) mit mehreren Lagerplätzen,
mit wenigstens einem Lagerregal (40) das wenigstens eine Regalsäule mit übereinander angeordneten Lagerplätzen aufweist, und
mit wenigstens einer Übergabevorrichtung (60), die ausgebildet und eingerichtet ist, das Lagergut (12) von einem Lagerplatz des Lagerregals (40) auf die Übergabevorrichtung (60) und von dort zu einem Lagerplatz des Umlauflagerregals (20, 30) und umgekehrt zu transportieren,
wobei die Übergabevorrichtung (60) in vertikaler und/oder horizontaler Richtung verfahrbar ist, **dadurch gekennzeichnet,**
**dass** ein Transportschacht (50) zwischen dem wenigstens einen Umlauflagerregal (20, 30) und dem wenigstens einen Lagerregal (40) vorgesehen ist, in dem die Übergabevorrichtung (60) verfahrbar ist,
wobei die Übergabevorrichtung (60) ausgebildet und eingerichtet ist, um das Lagergut (12) von einem Lagerplatz des Umlauflageregals (20, 30) auf die Übergabevorrichtung (60) und von dort in die Bedienöffnung (18) und umgekehrt zu transportieren und
wobei die Übergabevorrichtung (60) ausgebildet und eingerichtet ist, um das Lagergut (12) von einem Lagerplatz des Lagerregals (40) auf die Übergabevorrichtung (60) und von dort in die Bedienöffnung (18) und umgekehrt zu transportieren.

2. Lagerregalsystem (10) nach Anspruch 1, **dadurch gekennzeichnet, dass** die Übergabevorrichtung (60) einen Vertikalförderer (70), vorzugsweise in Form einer Plattform (74), umfasst, mit dem das Lagergut (12) in vertikaler Richtung verfahrbar ist.

3. Lagerregalsystem(10) nach einem der Ansprüche 1 oder 2, **dadurch gekennzeichnet, dass** die Übergabevorrichtung (60) wenigstens einen Horizontalförderer (80) umfasst, mit dem das Lagergut (12) in horizontaler Richtung verfahrbar ist.

4. Lagerregalsystem (10) nach Anspruch 3, **dadurch gekennzeichnet, dass** sich der Horizontalförderer (80) auf dem Vertikalförderer (70) abstützt und vorzugsweise bezüglich dem Vertikalförderer (70) in horizontaler Richtung bewegbar ist.

5. Lagerregalsystem (10) nach einem der vorhergehenden Ansprüche, **dadurch gekennzeichnet, dass** die Übergabevorrichtung (60), vorzugsweise der Horizontalförderer (80), wenigstens eine Übergabeeinheit umfasst, um das Lagergut (12) von einem Lagerplatz des Umlauflagerregals (20, 30) auf die Übergabevorrichtung (60) und/oder von einem Lagerplatz des Lagerregals (40) auf die Übergabevorrichtung (60) und/oder von der Übergabevorrichtung (60) in die Bedienöffnung (18) zu befördern.

6. Lagerregalsystem (10) nach einem der vorhergehenden Ansprüche, **dadurch gekennzeichnet, dass** das Umlauflagerregal (20, 30) ein Antriebsmittel aufweist, an dem über eine Trageinheit (27) ein Tragsatz (28) zur Halterung eines Lagergutträgers gehalten ist, wobei das Antriebsmittel vorzugsweise einen Kettenantrieb und/oder einen Zahnradantrieb umfasst.

7. Lagerregalsystem (10) nach Anspruch 6, **dadurch gekennzeichnet, dass** der jeweilige Tragsatz (28) fest an der zugehörigen Trageinheit (27) angebracht ist und zur Halterung des Lagergutträgers dient oder dass jeweilige Tragsatz (28) lösbar an der zugehörigen Trageinheit (27) angebracht ist und zur Halterung des Lagergutträgers dient.

8. Lagerregalsystem (10) nach einem der vorhergehenden Ansprüche, **dadurch gekennzeichnet, dass** Lagerregal (40) paarweise Trägerauflagen (44) aufweist, um die übereinanderliegenden Lagerplätze zu bilden.

9. Lagerregalsystem (10) nach einem der vorhergehenden Ansprüche, **dadurch gekennzeichnet, dass** Regalständer (16) zur Halterung der Seitenwände (42) des Lagerregalsystems, zur Führung der Übergabevorrichtung (60) in vertikaler Richtung, zur Stützung des Lagerregals (40) und/oder zur Stützung des Umlauflagerregals (20, 30) vorgesehen sind.

10. Lagerregalsystem (10) nach einem der vorhergehenden Ansprüche, **gekennzeichnet durch** wenigstens zwei Lagerregale (40), wenigstens ein Umlauflagerregal (20, 30) und wenigstens eine Übergabevorrichtung (60), vorzugsweise **gekennzeichnet durch** zwei Lagerregale (40), ein Umlauflagerregal (20, 30) und zwei Übergabevorrichtungen (60) oder vorzugsweise **gekennzeichnet durch** zwei Lagerregale (40), zwei Umlauflagerregale (20, 30) und eine Übergabevorrichtung (60).

11. Lagerregalsystem (10) nach einem der vorhergehenden Ansprüche, **dadurch gekennzeichnet, dass** das Umlauflagerregal (20, 30) wenigstens einen Übergabebereich aufweist, über den das Lagergut von dem Umlauflagerregal (20, 30) der Übergabevorrichtung (60) und umgekehrt zugeführt werden kann, wobei der Übergabebereich vorzugsweise im oberen Umlenkbereich (21), im unteren Umlenkbereich (22) und/oder in einem Bereich zwischen oberen Umlenkbereich (21) und unteren Umlenkbereich (22) des Umlauflagerregals (20, 30) ausgebildet ist.

## Claims

1. A storage shelf system (10) for storing storage goods, comprising
at least one service opening (18) for depositing and removing storage goods (12),
at least one revolving storage shelf unit (20, 30) with several storage locations, and
at least one storage shelf unit (40) which has at least one shelving column with storage locations disposed one above the other, and
at least one transfer device (60) configured and adapted for transporting the storage goods (12) from a storage location of the storage shelf unit (40) onto the transfer device (60) and thence to a storage location of the revolving storage shelf unit (20, 30) and vice versa,
wherein the transfer device (60) is movable in vertical and/or horizontal direction, **characterized in that**
a transport shaft (50) is provided between the at least one revolving storage shelf unit (20, 30) and the at least one storage shelf unit (40) and wherein the transfer device (60) is movable in the transport shaft (50),
wherein the transfer device (60) is configured and adapted for transporting the storage goods (12) from a storage location of the revolving storage shelf unit (20, 30) onto the transfer device (60) and thence into the service opening (18) and vice versa and
wherein the transfer device (60) is configured and adapted for transporting the storage goods (12) from a storage location of the storage shelf unit (40) onto the transfer device (60) and thence into the service opening (18) and vice versa.

2. The storage shelf system (10) according to claim 1, **characterized in that** the transfer device (60) comprises a vertical conveyor (70), preferably in the form of a platform (74), with which the storage goods (12) can be moved in the vertical direction.

3. The storage shelf system (10) according to any one of claims 1 or 2, **characterized in that** the transfer device (60) comprises at least one horizontal conveyor (80) with which the storage goods (12) can be moved in the horizontal direction.

4. The storage shelf system (10) according to claim 3, **characterized in that** the horizontal conveyor (80) is supported on the vertical conveyor (70) and is preferably movable in the horizontal direction relative to the vertical conveyor (70).

5. The storage shelf system (10) according to any one of the preceding claims, **characterized in that** the transfer device (60), preferably the horizontal conveyor (80), comprises at least one transfer unit in order to convey the storage goods (12) from a storage location of the revolving storage shelf unit (20, 30) onto the transfer device (60) and/or from a storage location of the storage shelf unit (40) onto the transfer device (60) and/or from the transfer device (60) into the service opening (18).

6. The storage shelf system (10) according to any one of the preceding claims, **characterized in that** the revolving storage shelf unit (20, 30) comprises a driving means on which a carrying assembly (28) for retaining a storage goods carrier is held by means of a carrying unit (27), the driving means preferably comprising a chain drive and/or a gear drive.

7. The storage shelf system (10) according to claim 6, **characterized in that** the respective carrying assembly (28) is firmly mounted on the associated carrying unit (27) and serves for retaining the storage goods carrier, or that the respective carrying assembly (28) is detachably mounted on the associated carrying unit (27) and serves for retaining the storage goods carrier.

8. The storage shelf system (10) according to any one of the preceding claims, **characterized in that** the storage shelf unit (40) comprises pairs of carrier supports (44) in order to form storage locations that are situated one above the other.

9. The storage shelf system (10) according to any one of the preceding claims, **characterized in that** shelving posts (16) are provided for retaining the side walls (42) of the storage shelf system, for guiding the transfer device (60) in the vertical direction, for supporting the storage shelf unit (40) and/or for supporting the revolving storage shelf unit (20, 30).

10. The storage shelf system (10) according to any one of the preceding claims, **characterized by** at least two storage shelf units (40), at least one revolving storage shelf unit (20, 30) and at least one transfer device (60), preferably **characterized by** two storage shelf units (40), one revolving storage shelf unit (20, 30) and two transfer devices (60), or preferably **characterized by** two storage shelf units (40), two revolving storage shelf units (20, 30) and one transfer device (60).

11. The storage shelf system (10) according to any one of the preceding claims, **characterized in that** the revolving storage shelf unit (20, 30) comprises at least one transfer region via which the storage goods can be fed from the revolving storage shelf unit (20, 30) to the transfer device (60) and vice versa, with the transfer region preferably being formed in the upper returning region (21), in the lower returning region (22), and/or in a region between the upper returning region (21) and the lower returning region (22) of the revolving storage shelf unit (20, 30).

## Revendications

1. Système de rayonnage de stockage (10) pour le stockage de produits à stocker,
comprenant au moins une ouverture de service (18) pour la mise en stock et pour l'enlèvement de produits (12),
comprenant au moins un rayonnage de stockage en recirculation (20, 30) avec plusieurs emplacements de stockage,
comprenant au moins un rayonnage de stockage (40) qui comporte au moins une colonne de rayonnage avec des emplacements de stockage agencés les uns au-dessus des autres, et
comprenant au moins un dispositif de transfert (60), qui est réalisé et conçu pour transporter les produits à stocker (12) depuis un emplacement de stockage du rayonnage de stockage (40) vers le dispositif de transfert (60), et pour les transporter depuis cet endroit jusqu'à un emplacement de stockage du rayonnage de stockage en recirculation (20, 30) et inversement,
dans lequel le dispositif de transfert (60) est déplaçable en direction verticale et/ou horizontale, **caractérisé en ce que**
une cage de transport (50) est prévue entre ledit au moins un rayonnage de stockage en recirculation (20, 30) et ledit au moins un rayonnage de stockage (40), cage dans laquelle le dispositif de transfert (60) est déplaçable,
dans lequel le dispositif de transfert (60) est réalisé et conçu pour transporter les produits à stocker (12) depuis un emplacement de stockage du rayonnage de stockage en recirculation (20, 30) vers le dispositif de transfert (60), et pour les transporter depuis cet endroit jusque dans l'ouverture de service (18) et inversement, et
dans lequel le dispositif de transfert (60) est réalisé et conçu pour transporter les produits à stocker (12) depuis un emplacement de stockage du rayonnage de stockage (40) vers le dispositif de transfert (60), et pour les transporter depuis cet endroit jusque dans l'ouverture de service (18) et inversement.

2. Système de rayonnage de stockage (10) selon la revendication 1, **caractérisé en ce que** le dispositif de transfert (60) inclut un convoyeur vertical (70), de préférence sous la forme de plate-forme (74), au moyen duquel les produits à stocker (12) sont déplaçables en direction verticale.

3. Système de rayonnage de stockage (10) selon l'une des revendications 1 ou 2, **caractérisé en ce que** le dispositif de transfert (60) inclut au moins un convoyeur horizontal (80) au moyen duquel les produits à stocker (12) sont déplaçables en direction horizontale.

4. Système de rayonnage de stockage (10) selon la revendication 3, **caractérisé en ce que** le convoyeur horizontal (80) est soutenu sur le convoyeur vertical (70) et est de préférence déplaçable en direction horizontale par rapport au convoyeur vertical (70).

5. Système de rayonnage de stockage (10) selon l'une des revendications précédentes, **caractérisé en ce que** le dispositif de transfert (60), de préférence le convoyeur horizontal (80), inclut au moins une unité de transfert, pour convoyer les produits à stocker (12) depuis un emplacement de stockage du rayonnage de stockage en recirculation (20, 30) vers le dispositif de transfert (60) ou pour les convoyer depuis un emplacement de stockage du rayonnage de stockage (40) vers le dispositif de transfert (60) et/ou depuis le dispositif de transfert (60) jusque dans l'ouverture de service (18).

6. Système de rayonnage de stockage (10) selon l'une des revendications précédentes,
**caractérisé en ce que** le rayonnage de stockage en recirculation (20, 30) comprend un moyen d'entraînement sur lequel est tenu un groupe porteur (28), via une unité porteuse (27), pour le maintien d'un support pour produits à stocker, et dans lequel le moyen d'entraînement inclut de préférence un entraînement à chaîne ou un entraînement à roues dentées.

7. Système de rayonnage de stockage (10) selon la revendication 6, **caractérisé en ce que** le groupe porteur (28) respectif est rapporté de manière fixe sur l'unité porteuse associée (27) et sert au maintien du support pour les produits à stocker, ou **en ce que** le groupe porteur respectif (28) est rapporté de façon détachable sur l'unité porteuse associée (27) et sert au maintien du support pour les produits à stocker.

8. Système de rayonnage de stockage (10) selon l'une des revendications précédentes, **caractérisé en ce que** le rayonnage de stockage (40) comprend des appuis porteurs (44) prévus par paires afin de former les emplacements de stockage disposés les uns au-dessus des autres.

9. Système de rayonnage de stockage (10) selon l'une des revendications précédentes, **caractérisé en ce qu'**il est prévu des montants de rayonnage (16) pour le maintien des parois latérales (42) du système de rayonnage de stockage, pour le guidage du dispositif de transfert (60) en direction verticale, pour le soutien du rayonnage de stockage (40) et/ou pour le soutien du rayonnage de stockage en recirculation (20, 30).

10. Système de rayonnage de stockage (10) selon l'une des revendications précédentes, **caractérisé par** au moins deux rayonnages de stockage (40), au moins un rayonnage de stockage en recirculation (20, 30) et au moins un dispositif de transfert (60), de préférence **caractérisé par** deux rayonnages de stockage (40), un rayonnage de stockage en recirculation (20, 30) et deux dispositifs de transfert (60), ou de préférence **caractérisé par** deux rayonnages de stockage (40), deux rayonnages de stockage en recirculation (20, 30) et un dispositif de transfert (60).

11. Système de rayonnage de stockage (10) selon l'une des revendications précédentes, **caractérisé en ce que** le rayonnage de stockage en recirculation (20, 30) comprend au moins une zone de transfert via laquelle les produits à stocker peuvent être transférés depuis le rayonnage de stockage en recirculation (20, 30) au dispositif de transfert (60) et inversement, et dans lequel la zone de transfert est réalisée de préférence dans la zone de déviation supérieure (21), dans la zone de déviation inférieure (22), et/ou dans une zone entre la zone de déviation supérieure (21) et la zone de déviation inférieure (22) du rayonnage de stockage en recirculation (20, 30).
